# EUROPÄISCHE PATENTSCHRIFT

(11) **EP 1 354 342 B1**
(45) Veröffentlichungstag und Bekanntmachung des Hinweises auf die Patenterteilung: **11.06.2014**
(21) Anmeldenummer: 02718022.3
(22) Anmeldetag: 14.01.2002
(51) Int. Cl.: H01L 21/335, H01L 21/338, H01L 21/285, H01L 29/66

(54) **VERFAHREN ZUR HERSTELLUNG EINES HALBLEITER-BAUELEMENTS MIT EINER T-FÖRMIGEN KONTAKTELEKTRODE**
METHOD FOR PRODUCING A SEMICONDUCTOR COMPONENT COMPRISING A T-SHAPED CONTACT ELECTRODE
PROCEDE POUR FABRIQUER UN COMPOSANT SEMI-CONDUCTEUR COMPORTANT UNE ELECTRODE DE CONTACT EN FORME DE T

(30) Priorität: 17.01.2001 DE 10101825
(43) Veröffentlichungstag der Anmeldung: 22.10.2003
(73) Patentinhaber: United Monolithic Semiconductors GmbH, 89081 Ulm (DE)
(72) Erfinder: BEHAMMER, Dag, 89079 Ulm (DE)
(74) Vertreter: Baur & Weber Patentanwälte
(86) Internationale Anmeldenummer: PCT/EP2002/000264
(87) Internationale Veröffentlichungsnummer: WO 2002/063671

(56) Entgegenhaltungen:
- EP-A- 0 591 608
- US-A- 5 391 510
- US-A- 5 399 896
- PATENT ABSTRACTS OF JAPAN vol. 016, no. 521 (E-1285), 27. Oktober 1992 (1992-10-27) -& JP 04 196135 A (SUMITOMO ELECTRIC IND LTD), 15. Juli 1992 (1992-07-15)
- PATENT ABSTRACTS OF JAPAN vol. 014, no. 502 (E-0997), 2. November 1990 (1990-11-02) & JP 02 208945 A (NEC CORP), 20. August 1990 (1990-08-20)
- "HIGH PERFORMANCE GAAS FET DEVICE STRUCTURE" IBM TECHNICAL DISCLOSURE BULLETIN, IBM CORP. NEW YORK, US, Bd. 31, Nr. 5, 1. Oktober 1988 (1988-10-01), Seiten 200-203, XP000024707 ISSN: 0018-8689

## Beschreibung

Die Erfindung betrifft ein Verfahren zur Herstellung eines Halbleiter-Bauelements mit einer im Querschnitt T-förmigen metallischen Kontaktelektrode, insbesondere eines Feldeffekt-Transistors mit einem T-förmigen Metallgate.

Bei Feldeffekt-Transistoren ist die Gatelänge eine die Grenzfrequenz des Transistors maßgeblich bestimmende Dimension, so daß für hohe Frequenzen eine möglichst geringe Gatelänge angestrebt wird. Andererseits soll auch der Zuleitungswiderstand der Gate-Elektrode möglichst gering sein. Die Merkmale geringer Gatelänge und niedrigen Zuleitungswiderstands sind insbesondere durch metallische Gate-Elektroden mit einem schmalen Gatefuß und einem demgegenüber breiten Gatekopf, sogenannten T-förmigen Elektroden (T-Gate) realisierbar.

Sehr kleine Gatelängen im Submikrometerbereich, insbesondere unter 0,2 µm, sind z. Z. in direkter optischer Lithographie nur in begrenzter Zuverlässigkeit herstellbar.

Aus der DE 39 11 512 A1 ist ein selbstjustierendes Verfahren zur Herstellung einer Steuerelektrode bekannt, bei welcher photolithographisch in einer Lackschicht Öffnungen für Strukturen von Source- und Drain-Elektroden erzeugt werden. Durch Unterätzen soll der Bereich zwischen den Source- und Drain-Strukturen auf ein schmales Dummy-Gate reduziert werden, welches in einem späteren Verfahrensstadium von einer neuen Lackschicht umgeben die Ätzung einer Gatekopfstruktur zentriert und vor Abscheiden des Gate-Metalls entfernt wird. Die Unterätzung führt aber im Realfall zu einer Dummy-Gate-Form mit verbreitertem Fuß. Die Unterätzung ist nicht mit ausreichender Präzision reproduzierbar. Zusätzlich ist der Abstand der Öffnungen für die Strukturen von Source- und Drain-Elektroden als Ausgangsbasis für die Breite des Dummy-Gate bei der direkten optischen Lithographie nicht hinreichend genau einstellbar.

Die Technik, eine laterale Struktur im Submikrometerbereich mittels einer an einer vertikalen Stufenflanke abgeschiedenen Schicht als Hilfsschicht genau einstellbarer Dicke zu definieren, ist an sich seit langem bekannt. Beispielsweise ist in IEEE Electron Device Letters, EDL-2, No. 1, January 1981, pp. 4 - 6 von Hunter et al., A New Edge-Defined Approach for Submicrometer MOSFET Fabrication ein Verfahren beschrieben, bei welchem zwei zu den Seitenflanken einer Stufenstruktur erzeugte Elemente mit lateralen Submikrometerabmessungen nach Entfernen der Stufenstruktur als Masken zur Erzeugung von sehr schmalen Gatestrukturen in darunterliegenden Schichten dienen. Solche an vertikalen Flanken erzeugten Elemente werden auch als Side-Spacer oder im folgenden auch einfach als Spacer bezeichnet.

Die DE 195 48 058 C2 beschreibt ein Verfahren zur Herstellung eines MOS-Transistors, bei welchem an beabstandeten Flanken einer photolithographisch erzeugten Struktur Spacer erzeugt werden, welche als Maske für eine nachfolgende Ätzung einer darunterliegenden leitenden ersten Elektrodenschicht dienen so dass unter den Spacern Materialstege als Gatefuß stehen bleiben. Eine darüber ganzflächig abgeschiedene zweite Elektrodenschicht wird photolithographisch zur Erzeugung eines Gatekopfs strukturiert.

In der EP 0 240 683 wird die Gatelänge eines GaAs-JFETs durch einen SiN-Spacer an einer vertikalen Kante einer Fotolackstruktur definiert. Nach einer Planarisierung des SiN-Spacers maskiert dieser die Ätzung der hochdotierten Cap-Schicht und definiert so das Gate des JFET.

Eine entsprechende Vorgehensweise ist zur Herstellung eines FET in Siliziumtechnologie aus der US 5 202 272 bekannt.

Die JP 04-196 135 A zeigt ein Verfahren zur Herstellung eines T-Gates mit geringer Gatelänge, indem an einer vertikalen Kante einer über einem Halbleitersubstrat abgeschiedenen Photolackmaske ein SiO₂-Spacer erzeugt wird, welcher als Dummy für den Gatefuß in einer Gatefuß-Schicht dient und wieder entfernt wird. In einer darüber abgeschiedenen Kopfschicht wird mit einer separaten Maske eine Öffnung als Struktur für den Gatekopf erzeugt. In einem einheitlichen Abscheidungsschritt wird das Gatemetall zur Bildung des T-förmigen Gates in die Lücke des Dummy-Gate und die Öffnung in der Kopfschicht abgeschieden. In einem Zwischenschritt kann der Spacer an der vertikalen Kante der Photolackmaske auch zur selbstausrichtenden Erzeugung eines niederohmigen Source-Bereichs dienen.

Bei einem aus der JP 02-208 945 bekannten Verfahren wird gleichfalls ein Spacer an einer vertikalen Kante als Dummy-Gate erzeugt und später unter zusätzlicher Ätzung eines recess-Grabens entfernt, bevor eine weitere Photolackschicht abgeschieden und in dieser über der Lücke des Dummy-Gates durch eine separate Maske eine Öffnung für die Struktur des Gatekopfes erzeugt wird. In die Öffnung der weiteren Photolackschicht und in die Lücke des Dummy-Gates wird Gatemetall zur Bildung eines T-förmigen Gates abgeschieden, überschüssiges Metall auf der weiteren Photolackschicht durch lift-off entfernt.

In der US 5 391 510 ist ein Verfahren beschrieben, bei welchem mittels eines Spacers an einer vertikalen Schichtkante ein Dummy-Gate erzeugt wird, welches von einer Isolatorschicht umgeben und unter Hinterlassung einer Lücke, welche die Struktur für den Gatefuß bildet, entfernt wird. Durch ganzflächiges Abscheiden einer Gatemetall-Schicht und nachfolgendes Ätzen wird das T-förmige Gate fertiggestellt.

Aus der EP 0 177 129 ist ein Verfahren bekannt, bei welchem das Gate direkt durch einen metallischen Spacer definiert wird, ohne daß aber ein breiterer Gatekopf erzeugt werden kann.

In der EP 0 591 608 A2 ist ein erstes Herstellungsverfahren beschrieben, welches optische Lithographie für den Gatekopf und Elektronenstrahllithographie für den Gatefuß mittels zweier übereinander abgeschiedener unterschiedlicher Photolackschichten kombiniert. Elektronenstrahllithographie ist aber ein teurer und zeitaufwendiger Schritt in der Produktion mit unbefriedigender Ausbeute.

In derselben Schrift wird daher ein neues Verfahren vorgeschlagen, bei welchem auf das Halbleitermaterial eine Isolatorschicht abgeschieden und in dieser mittels optischer Lithographie eine vertikale Stufe erzeugt wird. Eine flächig abgeschiedene Metallschicht schlägt sich auch an der vertikalen Stufenflanke nieder. Nach Planarisierung und Erzeugung einer Gatekopf-Maske über der vertikalen Stufe kann die Metallschicht an der Stufenflanke entfernt werden. Die dabei entstehende Lücke dient als Maske für die Ätzung eines Recess-Grabens und für die Abscheidung des Gatefuß-Metalls. Die Schichtdicke der an der Stufenflanke abgeschiedenen Metallschicht läßt sich nach bekannten Verfahren sehr genau einstellen, so daß zuverlässig eine sehr geringe Gatelänge realisierbar ist. Allerdings ergibt sich durch die getrennten Lithographieschritte für die vertikale Stufe einerseits und die Gatekopf-Maske die Gefahr einer Fehlausrichtung zwischen Gatefuß und Gatekopf.

Das bekannte Verfahren umfaßt weitere nachteilige Schritte, insbesondere in dem im fortgeschrittenen Stadium der Herstellung, Ätzprozesse bei offenem Recessgraben und/oder teilweise freiliegenden Halbleiter-Kontaktschichten, welche die Eigenschaften des Bauelements nachteilig beeinflussen können.

Bei einem aus der US 5 399 896 bekannten Verfahren wird zunächst mit einem ersten Spacer (outside spacer) an einer Stufenflanke und mittels einer Al-Implantation ein Recessgraben definiert und an den dabei entstehenden Seitenflanken des Recessgrabens werden einander zugewandt weitere Spacerschichten (inside spacer) erzeugt, deren lateraler Abstand die Gatelänge bestimmt und mit Gatemetall aufgefüllt wird. Die tatsächlich entstehende Gatelänge hängt von den lateralen Abmessungen des ersten und der weiteren Spacer ab, welche wiederum durch die Höhen der jeweiligen vertikalen Stufen beeinflußt sind. Durch die Vielzahl der die Gatelänge beeinflussenden Parameter ist eine schlechte Reproduzierbarkeit der Gatelänge zu erwarten. Nachteilig an dem Verfahren ist ferner, daß bei der zweiten Spacerätzung der Recessboden geschädigt werden kann, was zu einer Verschlechterung der Bauelementeigenschaften führen kann.

Der Erfindung liegt die Aufgabe zugrunde, ein vorteilhaftes Verfahren zur Herstellung einer T-förmigen Elektrode mit sehr schmalem Elektrodenfuß anzugeben.

Die Erfindung ist im Patentanspruch 1 beschrieben. Die abhängigen Ansprüche enthalten vorteilhafte Ausgestaltungen und Weiterbildungen der Erfindung. Die Erfindung ist nachfolgend anhand des bevorzugten Einsatzes für die Herstellung einer Gateelektrode eines Feldeffekttransistors als Elektrode eines Halbleiterbauelements beschrieben, ohne aber hierauf beschränkt zu sein.

Die Erfindung macht sich die an sich bekannte und eingangs ausführlich beschriebene Technik zur Erzeugung sehr feiner lateraler Strukturen mittels einer an einer vertikalen Materialkante abgeschiedenen Hilfsschicht als Spacer, dessen Schichtdicke die Breite des Gatefusses bestimmt, zunutze, setzt aber darüber hinaus diesen Spacer auch als Positionierungsmaske für den gegenüber dem Gatefuß wesentlich breiteren Gatekopf ein. Zum einen kann dadurch ausschließlich optische Lithographie eingesetzt werden, zum anderen sind durch die Selbstausrichtung von Gatekopf und Gatefuß Justierungsfehler wie bei mehreren Lithographieschritten ausgeschlossen. Die Gatelänge wird im wesentlichen durch die Dicke der Hilfsschicht des Spacers, die Steilheit der Materialkante und die Anisotropie und Homogenität der Spacerätzung definiert. Diese Größen sind jedoch mit bekannten Verfahren und insbesondere bei Einsatz trockenchemischer Prozesse hinreichend präzis einstellbar und kontrollierbar.

Vorzugsweise wird der Spacer bis zu einer Höhe über dem Halbleitermaterial erzeugt, welche über der Höhe des herzustellenden Gatekopfes liegt. Insbesondere kann vorgesehen sein, beidseitig um den Spacer eine im folgenden als Kopfschicht bezeichnete Materialschicht zu erzeugen, in welcher später eine Struktur für die Herstellung des Gatekopfes erzeugt wird. Die Spitze des Spacers ragt vorzugsweise über diese Kopfschicht hinaus. Die Kopfschicht kann beispielsweise aus einem Photolack bestehen und wird vorzugsweise planarisiert.

Über dem Spacer, insbesondere über der Kopfschicht mit der darüber hinaus ragenden Spacerspitze können weiter Schichten abgeschieden werden. Insbesondere kann eine der Kontur des Spacers bzw. der Spacerspitze folgende Konturschicht vorgesehen sein, welche im Bereich des Spacers durch eine über ihr abgeschiedene Deckschicht hindurchragt. Durch definierte Ätzung der Konturschicht mit Unterätzung der Deckschicht kann in der Konturschicht eine zum Spacer zentrierte, gegenüber diesem erweiterte Öffnung als Maske für die breitere Gatekopfstruktur erzeugt werden. In der Kopfschicht wird für den Gatekopf vorteilhafterweise ein sich zum Gatefuß hin verjüngendes Profil erzeugt, welches zu einer seitlich nach oben gewölbten Unterseite des Gatekopfes mit geringer Kapazität zu Source und Drain und insbesondere zu einen ausläuferfreien Kopfprofil führt. Vorzugsweise werden Gatefuß und Gatekopf in einem einzigen Prozeßschritt, insbesondere durch Aufdampfen von Gateelektroden-Metall erzeugt.

Vorteilhafterweise wird das Halbleitermaterial vor der Erzeugung des Spacers mit einer Schutzschicht, beispielsweise einer Nitridschicht überzogen, in welcher nach der Auflösung des Spacers eine Öffnung zum Halbleitermaterial erzeugt wird und welche erst nach Abscheiden des Gateelektroden-Metalls entfernt wird. Diese Schutzschicht bewahrt die Halbleiteroberfläche vor Schädigungen im Verlauf der Herstellung der Gateelektrode insbesondere bei den verschiedenen Ätzprozessen. Ein den Gatefuß umgebender Recess im Halbleitermaterial wird vorzugsweise in einem vor der Abscheidung des Gateelektroden-Metalls letzten Ätzschritt erzeugt, so daß die besonders kritische Halbleiteroberfläche des Recessbodens keinen eventuell schädigenden Einflüssen anderer Prozeßschritte ausgesetzt ist. Diese Schutzmaßnahmen sind auch bei anderer Vorgehensweise zur Herstellung einer Gateelektrode vorteilhaft.

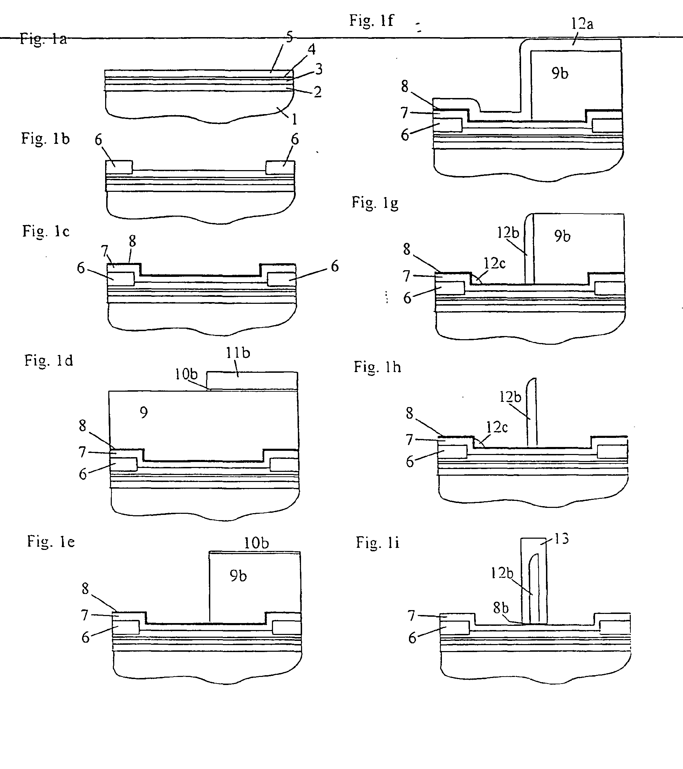

Die Erfindung ist nachfolgend anhand eines bevorzugten Ausführungsbeispiels unter Bezugnahme auf die Abbildungen Fig. 1a bis Fig. 1r, welche eine besonders vorteilhafte Prozeßabfolge zur Herstellung eines PHEMT in einem Verbindungshalbleitermaterial zeigen, noch eingehend veranschaulicht.

Im folgenden wird die Erfindung anhand von einem Ausführungsbeispiel unter Bezugnahme auf schematische Zeichnungen in den Figuren näher erläutert. Es zeigen
- Fig. 1a - 1r: Prozeßschritte zur Herstellung eines PHEMT mit selbstjustiertem T-Gate.

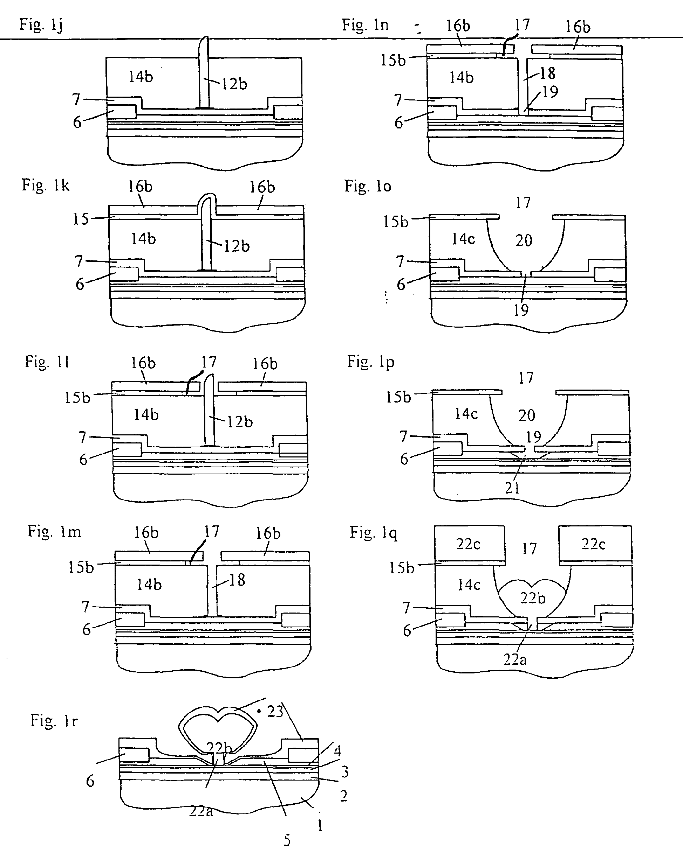

Ausgehend von dem GaAs Substrat 1 definieren die epitaktisch erzeugten Schichten 2 - 5 das Vertikalprofil des Transistors, das in seiner Dicken- und Elementstruktur im Einzelfall auf die jeweilige Anwendung abgestimmt ist. Typischerweise stellt 2 den Buffer dar, 3 bildet das zweidimensionale Elektronengas (der Kanal), 4 ist eine Stopschicht, die zur definierten Ätzung des Recessgrabens beiträgt, und 5 die hochdotierte Kontaktschicht (Fig. 1a). Nach Definition der ohmschen Kontakte 6 für Source und Drain in Fig. 1b erfolgt die PECVD Abscheidung einer Nitrid (Si₃N₄)-Schicht 7 als Schutzschicht und das Aufbringen einer metallischen Stopschicht 8 (siehe Fig. 1c). Im folgenden wird die temperaturstabile Lackschicht 9 (z. B. PMGI, PMMA oder Polyimid) und die anorganische Schicht 10 aufgebracht, in die durch die Fotolackmaske 11b die Struktur 10b durch reaktives Ionen Ätzen (RIE) übertragen wird. Die Maske 10b maskiert dann eine trockenchemische Plasmaätzung der temperaturstabilen Lackschicht 9 und definiert somit die Struktur 9b, mit der Materialstufe, die sich durch eine hohe Flankensteilheit auszeichnet und keinen Lackfuß am Übergang zur Stopschicht 8 aufweist (siehe Fig. 1d und e). Beide Eigenschaften lassen sich durch an sich bekannte Parametereinstellung der verwendeten RIE Ätzung erzeugen. Nach der Entfernung der Maske 10b erfolgt eine PECVD Abscheidung der Oxidschicht 12a, die durch die nachfolgende anisotrope Ätzung einen Spacer 12b an der Lackkante bildet. Je nach Topographie der ohmschen Kontakte 6 können weitere parasitäre Spacer 12c entstehen (Fig. 1f und g). Nach der Entfernung der temperaturstabilen Lackschicht 9, in Abhänigigkeit von der chemischen Zusammensetzung z. B. im Sauerstoffplasma oder auf naßchemischem Wege (Fig. 1 h), werden durch einen Fotoschritt die Gebiete 13 geschützt, in denen der Oxidspacer 12b erhalten bleiben soll. Die Strukturgröße und die Justage von 13 zu 12b sind sehr unkritisch. Die parasitären Oxidspacer 12c sowie die nicht durch 13 abgedeckte Stopschicht 8 werden entfernt (Fig. 1i).

Eine weitere Lackschicht 14 planarisiert die Oberfläche so, daß nach einer homogenen trockenchemischen Lackausdünnung die rückgeätzte Lackschicht 14b den oberen Teil des Spacers 12b freilegt (Fig. 1j). Dieser Prozeßschritt wird mit einem dünneren Lack als Deckschicht 16 nach der Abscheidung einer anorganischen Schicht 15, welche der Kontur des Spacers 12b folgt, wiederholt, so daß die Konturschicht 15 nur am Spacer 12b über der Deckschicht sichtbar ist (Fig. 1 k). Vor dem Ausdünnen kann in 16 zusätzlich eine nicht skizzierte Struktur für ein Gatekontaktbereich belichtet werden. Maskiert durch den rückgeätzten Fotolack 16b und selektiv zum Oxidspacer 12 wird die anorganische Schicht 15 geätzt. Dabei ist die Selektivität zum Fotolack ausreichend groß gewählt und die trockenchemische Ätzung besitzt einen hohen isotropen Anteil. Dadurch kann eine definierte Unterätzung erreicht werden. Die entstehende Struktur 15b der Konturschicht bestimmt mit der Öffnung 17 die Größe des Gatekopfes (Fig. 1 k). Durch naßchemische Entfernung des Oxidspacers 12b und der Stopschicht 8 entsteht das Loch 18, das zusammen mit 16b die anschließende Plasmaätzung der Schutzschicht 7 maskiert (Fig. 1m und n).

Das entstehende Loch 19 in der Schutzschicht 7 maskiert später die naßchemische Ätzung des Recess.

Durch eine weitere trockenchemische Ätzung der Kopfschicht mit der Öffnung 17 in der Konturschicht 15b als Maske 14b wird ein Wannenprofil 20 erzeugt, das einerseits einen deutlichen Unterschnitt zu 15b besitzt und andererseits noch große Teile des Bodens über der Schutzschicht 7 bedeckt (Fig. 1o). Durch diese Form kann gewährleistet werden, daß ein späterer Gate Lift-off gut ist und das ansonsten typische Auslaufprofil der unteren Fläche des Gatekopfes bei der Bedampfung vermieden wird. Nach der Ätzung des Recessgrabens 21 (Fig. 1 p) erfolgt die Gatebedampfung 22 (Fig. 1 q).

Dabei stellt 22a den Gatefuß und 22b den Gatekopf dar. Im folgenden Lift-off Process wird der Fotolack 14c naßchemisch entfernt und hebt dabei die Schichten 15b und 22c ab. Nach Entfernung der Nitrid-Schutzschicht 7 wird der Transistor mit einer Passivierungsschicht 23, z. B. einer Si₃N₄-Schicht passiviert und durch weitere Schritte in üblicher Weise mit passiven Bauelementen kontaktiert.

Die Erfindung ist besonders vorteilhaft für Feldeffekttransistoren in Verbindungshalbleitermaterialien, insbesondere in pseudomorpher oder metamorpher III-V-HEMT-Technologie, wo die Gatelänge und die Weite des Recessgrabens geometrisch besonders kritische laterale Größen unterhalb 0,2 µm sind, wogegen die übrigen lateralen Abmessungen wesentlich größer und unkritischer sind.

Die vorstehend und die in den Ansprüchen angegebenen sowie die den Abbildungen entnehmbaren Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens in mancherlei Weise abwandelbar.

## Patentansprüche

1. Verfahren zur Herstellung eines Halbleiter-Bauelements mit einer im Querschnitt T-förmigen metallischen Kontakt-Elektrode auf einem Halbleitermaterial, wobei:
a) ein Spacer (12b) aus einer an einer Materialkante abgeschiedenen Hilfsschicht (9b) erzeugt wird und die Position und Breite des Elektrodenfußes durch den Spacer bestimmt ist, wobei
b) nach Entfernung der Hilfsschicht (9b) eine Kopfschicht (14b) um den Spacer (12b) abgeschieden wird, wobei die Spitze des Spacers über die Kopfschicht hinausragt;
c) auf der Kopfschicht (14b) und der Spacerspitze eine Konturschicht (15) und auf dieser eine Deckschicht (16) abgeschieden und durch Teilabtrag der Deckschicht die Konturschicht (15) über dem Spacers freigelegt wird;
d) die Konturschicht (15) geätzt wird, und durch Unterätzung unter der Deckschicht (16) in der Konturschicht (15) eine erweiterte Öffnung (17) um den Spacer (12b) als Maske für die Herstellung des Elektrodenkopfes (22b) freigelegt wird;
e) der Spacer (12b) entfernt wird;
f) eine Öffnung (19) in wenigstens eine unter der Kopfschicht (14b) liegende Schicht (7) geätzt wird, um Breite und Position des Elektrodenfußes (22a) zu bestimmen;
g) in der Kopfschicht eine Öffnung (20) für die Herstellung des Elektrodenkopfes (22b) erzeugt wird, welche Position und Breite des Elektrodenkopfes bestimmt;
h) Elektrodenfuß (22a) und Elektrodenkopf (22b) in dieser Öffnung (2a) abgeschieden werden; und
i) die Elektrode freigelegt wird.

2. Verfahren nach Anspruch 1, **dadurch gekennzeichnet, daß** die Öffnung (20) in der Kopfschicht (14b) als ein sich nach unten zum Elektrodenfuß (22a) verjüngendes Profil freigelegt wird.

3. Verfahren nach Anspruch 1 oder 2, **dadurch gekennzeichnet, daß** nach Erzeugung der Öffnung (20) under Kopfschicht (14b) ein Recessgraben (21) in einer Halbleiterschicht unter der unter der Kopfschicht (14b) liegenden Schicht (7) durch die Öffnung (14) under Schicht (7) geätzt wird.

4. Verfahren nach Anspruch 3, **dadurch gekennzeichnet, daß** die Ätzung des Recessgrabens als letzter Ätzschritt vor Abscheiden des Elektrodenfußes (22a) vorgenommen wird, wobei der Elektrodenfuß metallisch ist.

5. Verfahren nach einem der Ansprüche 1 bis 4, **dadurch gekennzeichnet, daß** Elektrodenfuß (22a) und Elektrodenkopf (22b) in einem Verfahrensschritt hergestellt werden, insbesondere durch Aufdampfen des Elektrodenmetalls.

6. Verfahren nach einem der Ansprüche 1 bis 5, **dadurch gekennzeichnet, daß** die unter der Kopfschicht (14b) liegende Schicht (7) vor der Erzeugung des Spacers als Schutzschicht (7) auf dem Halbleitermaterial abgeschieden wird , um die Oberfläche des Halbleitermaterials vor Schädigungen im Verlauf der Herstellung der Electrode zu bewahren.

## Claims

1. Method for producing a semiconductor component having a metallic contact electrode that is T-shaped in cross section on a semiconductor material, wherein:
a) a spacer (12b) is produced from an auxiliary layer (9b) deposited on a material edge, and the position and width of the electrode base is determined by the spacer, wherein
b) after the removal of the auxiliary layer (9b), a head layer (14b) is deposited around the spacer (12b), wherein the tip of the spacer projects above the head layer;
c) a contour layer (15) is deposited on the head layer (14b) and on the spacer tip and a covering layer (16) is deposited on said contour layer and the contour layer (15) is uncovered above the spacer by partial removal of the covering layer;
d) the contour layer (15) is etched, and, by undercutting under the covering layer (16), in the contour layer (15), an extended opening (17) is uncovered around the spacer (12b) as mask for the production of the electrode head (22b);
e) the spacer (12b) is removed;
f) an opening (19) is etched into at least one layer (7) lying below the head layer (14b) in order to determine the width and position of the electrode base (22a) ;
g) an opening (20) for the production of the electrode head (22b) is produced in the head layer, said opening determining the position and width of the electrode head;
h) the electrode base (22a) and the electrode head (22b) are deposited in the said opening (20); and
i) the electrode is uncovered.

2. Method according to Claim 1, **characterized in that** the opening (20) in the head layer (14b) is uncovered as a profile tapering downwards to the electrode base (22a).

3. Method according to Claim 1 or 2, **characterized in that**, after the production of the opening (20) in the head layer (14b), a recess trench (21) is etched in a semiconductor layer below the layer (7) lying below the head layer (14b) through the opening (19) in the layer (7).

4. Method according to Claim 3, **characterized in that** the etching of the recess trench is performed as a last etching step before the deposition of the electrode base (22a), the electrode base being metallic.

5. Method according to any of Claims 1 to 4, **characterized in that** the electrode base (22a) and the electrode head (22b) are produced in one method step, in particular by vapour deposition of the electrode metal.

6. Method according to any of Claims 1 to 5, **characterized in that**, before the production of the spacer, the layer (7) lying below the head layer (14b) is deposited as a protective layer (7) on the semiconductor material, in order to protect the surface of the semiconductor material against damage in the course of the production of the electrode.

## Revendications

1. Procédé pour fabriquer un composant semi-conducteur comportant une électrode de contact métallique à section transversale en forme de T sur un matériau semi-conducteur, dans lequel:
a) on produit un écarteur (12b) en une couche auxiliaire (9b) déposée sur un bord du matériau et la position et la largeur du pied d'électrode sont déterminées par l'écarteur, dans lequel
b) après l'enlèvement de la couche auxiliaire (9b), on dépose une couche supérieure (14b) autour de l'écarteur (12b), la pointe de l'écarteur sortant au-dessus de la couche supérieure;
c) sur la couche supérieure (14b) et sur la pointe de l'écarteur, on dépose une couche de contour (15) et sur celle-ci une couche de recouvrement (16) et on découvre la couche de contour (15) au-dessus de l'écarteur par enlèvement partiel de la couche de recouvrement;
d) on grave la couche de contour (15) et, par gravure inférieure sous la couche de recouvrement (16), on dégage dans la couche de contour (15) une ouverture élargie (17) autour de l'écarteur (12b) comme masque pour la fabrication de la tête d'électrode (22b);
e) on enlève l'écarteur (12b);
f) on grave une ouverture (19) dans au moins une couche (7) située sous la couche supérieure (14b), afin de déterminer la largeur et la position du pied d'électrode (22a);
g) on produit dans la couche supérieure une ouverture (20) pour la fabrication de la tête d'électrode (22b), qui détermine la position et la largeur de la tête d'électrode;
h) on dépose le pied d'électrode (22a) et la tête d'électrode (22b) dans cette ouverture (20); et
i) on dégage l'électrode.

2. Procédé selon la revendication 1, **caractérisé en ce que** l'on dégage l'ouverture (20) dans la couche supérieure (14b) sous la forme d'un profil se rétrécissant vers le bas jusqu'au pied d'électrode (22a).

3. Procédé selon la revendication 1 ou 2, **caractérisé en ce que**, après production de l'ouverture (20) dans la couche supérieure (14b), on grave un cratère en retrait (21) dans une couche semiconductrice sous la couche (7) située sous la couche supérieure (14b) à travers l'ouverture (19) dans la couche (7).

4. Procédé selon la revendication 3, **caractérisé en ce que** l'on effectue la gravure du cratère en retrait comme dernière étape de gravure avant le dépôt du pied d'électrode (22a), dans lequel le pied d'électrode est métallique.

5. Procédé selon l'une quelconque des revendications 1 à 4, **caractérisé en ce que** l'on fabrique le pied d'électrode (22a) et la tête d'électrode (22b) en une étape, notamment en vaporisant le métal d'électrode.

6. Procédé selon l'une quelconque des revendications 1 à 5, **caractérisé en ce que** l'on dépose la couche (7) située sous la couche supérieure (14b) comme couche de protection (7) sur le matériau semi-conducteur, avant la production de l'écarteur, pour préserver la surface du matériau semi-conducteur de dommages au cours de la fabrication de l'électrode.
